# EUROPEAN PATENT APPLICATION

(11) **EP 4 593 240 A1**
(43) Date of publication of application: **30.07.2025**
(21) Application number: 25153636.3
(22) Date of filing: 23.01.2025
(51) Int. Cl.: H02J 7/00

(54) **BATTERY MANAGEMENT SYSTEM AND RELATED DEVICE**

(30) Priority: 27.01.2024 CN 202410119471
(71) Applicant: Huawei Digital Power Technologies Co., Ltd., Shenzhen, Guangdong 518043 (CN)
(72) Inventor: WANG, Wencheng, Shenzhen, 518043 (CN); ZHOU, Li, Shenzhen, 518043 (CN); CUI, Zhaohuan, Shenzhen, 518043 (CN)
(74) Representative: Isarpatent

(57) **Abstract**

This application provides a battery management system and a related device. The BMS includes a first BMU and a second BMU. Inside the first BMU, a first BMIC is connected between a first-type input port and a first-type output port, and a second-type input port is connected to a second-type output port. Inside the second BMU, a second BMIC is connected between a second-type input port and a second-type output port, and a first-type input port is connected to a first-type output port. The first BMIC and the second BMIC support different communication protocols. The first-type output port of the first BMU is connected to the first-type input port of the second BMU, and the second-type output port of the first BMU is connected to the second-type input port of the second BMU, so that the first BMU communicates with the second BMU. Based on this application, BMUs of different types of BMICs can be used together in a same battery management system, and system compatibility is better.

## Description

### TECHNICAL FIELD

This application relates to the field of battery energy storage technologies, and in particular, to a battery management system and a related device.

### BACKGROUND

A battery management system (Battery Management System, BMS) is mainly configured to monitor a status of each battery unit in real time and intelligently manage and maintain each battery unit, to prevent overcharge and overdischarge of each battery unit, thereby prolonging a service life of each battery.

Currently, the BMS includes a main control unit and a plurality of battery monitoring units (battery monitoring unit, BMU), and each BMU includes one battery management integrated circuit (battery management integrated circuit, BMIC). BMICs in the plurality of BMUs are chips of a same manufacturer, and the BMICs in the plurality of BMUs communicate with each other through daisy-chain communication (daisy-chain communication). The main control unit sequentially activates the BMICs in the plurality of BMUs by using a communication conversion component inside the main control unit, and completes address assignment for the BMICs in the plurality of BMUs, to implement normal communication between the main control unit and the plurality of BMUs. However, when the BMICs in the plurality of BMUs are chips of different manufacturers, the chips of the different manufacturers use different daisy-chain communication protocols. As a result, the BMICs in the plurality of BMUs are incompatible with each other, and applicability is poor.

### SUMMARY

This application provides a battery management system and a related device, so that BMUs of different types of BMICs can be used together in a same battery management system, and system compatibility is better.

According to a first aspect, this application provides a battery management system BMS. The BMS includes a first battery monitoring unit BMU and a second BMU. A communication protocol supported by a first battery management integrated circuit BMIC included in the first BMU is different from a communication protocol supported by a second BMIC included in the second BMU. Each of the first BMU and the second BMU is configured to: manage one or more cells in a battery pack, and collect cell data of the one or more cells in the battery pack. Each of the first BMU and the second BMU includes a first-type input port, a first-type output port, a second-type input port, and a second-type output port. Inside the first BMU, the first BMIC is connected between the first-type input port of the first BMU and the first-type output port of the first BMU, and the second-type input port of the first BMU is connected to the second-type output port of the first BMU. The first-type input port, the first-type output port, and the first BMIC in the first BMU support a same communication protocol, and the communication protocol is different from a communication protocol supported by the second-type input port and the second-type output port of the first BMU. Inside the second BMU, the second BMIC is connected between the second-type input port of the second BMU and the second-type output port of the second BMU, and the first-type input port of the second BMU is connected to the first-type output port of the second BMU. The second-type input port, the second-type output port, and the second BMIC in the second BMU support a same communication protocol, and the communication protocol is different from a communication protocol supported by the first-type input port and the first-type output port of the second BMU. The first-type output port of the first BMU is connected to the first-type input port of the second BMU, and the second-type output port of the first BMU is connected to the second-type input port of the second BMU, so that the first BMU communicates with the second BMU. This embodiment of this application is implemented, so that two types of input/output ports can be disposed in each BMU to respectively provide corresponding data transmission channels for the first BMIC and the second BMIC. In this way, BMUs of different types of BMICs can be used together in a same battery management system, and system compatibility is better. In addition, when a BMIC in any BMU is faulty, the faulty BMIC may be replaced by using the first BMIC or the second BMIC, to ensure reliability of timely supply of the chip and timely replacement of the chip spare part. Moreover, there are no limitations brought by cases in which a single BMIC is short of supply or out of production, and applicability is stronger.

In a possible implementation, the first-type input port includes a first high-level input port and a first low-level input port, and the first-type output port includes a first high-level output port and a first low-level output port. The second-type input port includes a second high-level input port and a second low-level input port, and the second-type output port includes a second high-level output port and a second low-level output port. Inside the first BMU, the first high-level input port is connected to the first high-level output port via the first BMIC, the first low-level input port is connected to the first low-level output port via the first BMIC, the second high-level input port is connected to the second high-level output port, and the second low-level input port is connected to the second low-level output port. Inside the second BMU, the first high-level input port is connected to the first high-level output port, the first low-level input port is connected to the first low-level output port, the second high-level input port is connected to the second high-level output port via the second BMIC, and the second low-level input port is connected to the second low-level output port via the second BMIC. This embodiment of this application is implemented, external interfaces of circuit boards of the first BMU and the second BMU can be completely the same, and design sizes of the first BMU and the second BMU can be completely the same, so that physical structure installation of the first BMU and physical structure installation of the second BMU can be completely compatible, and harness connectors of the first BMU and the second BMU can be completely compatible. In addition, after the BMIC in the BMU is faulty, either the first BMIC or the second BMIC may be directly installed and replace the faulty BMIC, and an external cable of the BMIC and an external cable of the BMU do not need to be replaced. Therefore, component replacement costs are lower.

In a possible implementation, the first high-level output port of the first BMU is connected to the first high-level input port of the second BMU, and the first low-level output port of the first BMU is connected to the first low-level input port of the second BMU. In addition, the second high-level output port of the first BMU is connected to the second high-level input port of the second BMU, and the second low-level output port of the first BMU is connected to the second low-level input port of the second BMU, so that the first BMU communicates with the second BMU to transmit a differential signal of the cell data sampled by the BMU.

In a possible implementation, the BMS further includes a main control unit, and the main control unit is configured to: manage a plurality of battery packs, and receive cell data reported by each BMU in the plurality of battery packs. The plurality of battery packs include battery packs in which the first BMU and the second BMU are located, and the battery packs in which the first BMU and the second BMU are located may be a same battery pack, or may be different battery packs. The main control unit includes a first-type communication output port, a first-type communication input port, a second-type communication output port, and a second-type communication input port. To implement communication between the main control unit and the BMU, the first-type communication output port is connected to the first-type input port of the first BMU, the first-type communication input port is connected to the first-type output port of the second BMU, the second-type communication output port is connected to the second-type input port of the first BMU, and the second-type communication input port is connected to the second-type output port of the second BMU. The first-type communication output port, the first-type input port of the first BMU, and the first BMIC support a same communication protocol, and the first-type communication input port and the first-type output port of the second BMU support a same communication protocol. The second-type communication output port and the second-type input port of the first BMU support a same communication protocol, and the second-type communication input port, the second-type output port of the second BMU, and the second BMIC support a same communication protocol. This embodiment of this application is implemented, so that two types of communication output ports can be disposed inside the main control unit to deliver control instructions to the first BMU and the second BMU, and two types of communication input ports can be disposed inside the main control unit to receive the differential signals of the cell data reported by the first BMU and the second BMU. In this way, the main control unit communicates with the first BMU and the second BMU.

In a possible implementation, the first-type output port of the second BMU is configured to connect to a first-type input port of a third BMU, and the second-type output port of the second BMU is configured to connect to a second-type input port of the third BMU, so that the second BMU communicates with the third BMU. Inside the third BMU, the first-type input port of the third BMU is configured to connect to a first-type output port of the third BMU, and the second-type input port of the third BMU is configured to connect to a third BMIC of the third BMU. The third BMIC and the second BMIC support a same communication protocol. This embodiment of this application is implemented, so that the BMUs of the different types of BMICs can be used together in the same battery management system, and the system compatibility is better.

According to a second aspect, this application provides a battery monitoring unit BMU. The BMU is configured to manage one or more cells, and the BMU includes a first-type input port, a first-type output port, a second-type input port, a second-type output port, and a battery management integrated circuit BMIC. The first-type input port is connected to the first-type output port, and the second-type input port is connected to the second-type output port. When the BMIC is connected between the first-type input port and the first-type output port, the BMIC, the first-type input port, and the first-type output port support a same communication protocol, and the communication protocol is different from a communication protocol supported by the second-type input port and the second-type output port. Optionally, when the BMIC is connected between the second-type input port and the second-type output port, the BMIC, the second-type input port, and the second-type output port support a same communication protocol, and the communication protocol is different from a communication protocol supported by the first-type input port and the first-type output port. This embodiment of this application is implemented, so that when the BMIC in the BMU is faulty, the original BMIC may be replaced by using the BMIC of the communication protocol supported by the first-type input/output port, or the original BMIC may be replaced by using the BMIC of the communication protocol supported by the second-type input/output port, to ensure reliability of timely supply of the chip and timely replacement of the chip spare part. Moreover, there are no limitations brought by cases in which a single BMIC is short of supply or out of production, and applicability is stronger.

In a possible implementation, the first-type input port includes a first high-level input port and a first low-level input port, and the first-type output port includes a first high-level output port and a first low-level output port. The second-type input port includes a second high-level input port and a second low-level input port, and the second-type output port includes a second high-level output port and a second low-level output port. The first high-level input port is connected to the first high-level output port via the BMIC, the first low-level input port is connected to the first low-level output port via the BMIC, the second high-level input port is connected to the second high-level output port, and the second low-level input port is connected to the second low-level output port. Optionally, the first high-level input port is connected to the first high-level output port, the first low-level input port is connected to the first low-level output port, the second high-level input port is connected to the second high-level output port via the BMIC, and the second low-level input port is connected to the second low-level output port via the BMIC. This embodiment of this application is implemented, a differential signal of cell data sampled by the BMU may be transmitted through the first-type input/output port.

According to a third aspect, this application provides a battery management system BMS. The BMS includes a main control unit and at least two wireless communication links, and any two of the at least two wireless communication links use different communication protocols. In other words, at least two communication protocols are used for the at least two wireless communication links, and the at least two communication protocols may be communication protocols used by at least two wireless BMICs. There may be one or more links of each of the at least two wireless communication links. When there are the plurality of links of each wireless communication link, communication protocols used by the plurality of wireless communication links are a same communication protocol. The main control unit is configured to: manage a plurality of battery packs, and receive cell data reported by each BMU in the plurality of battery packs, and the BMU is configured to manage one or more cells in the battery pack. The main control unit includes at least two wireless communication modules that one-to-one correspond to the at least two wireless communication links. Each of the at least two wireless communication links includes one or more battery monitoring units BMUs. When each wireless communication link includes the plurality of BMUs, a BMU that is in the plurality of BMUs and that is closest to the wireless communication module corresponding to each wireless communication link performs wireless communication with the wireless communication module corresponding to each wireless communication link, and two adjacent BMUs in the plurality of BMUs perform wireless communication. This embodiment of this application is implemented, so that the at least two wireless communication links can use the communication protocols of the at least two wireless BMICs. Therefore, the at least two wireless communication links can use BMUs of the at least two wireless BMICs, so that different types of wireless BMICs can be used together in a same battery management system, and system compatibility is better.

According to a fourth aspect, this application provides a battery pack. The battery pack includes one or more first cells, one or more second cells, and the BMS according to the first aspect. The first BMU is configured to collect cell data of the one or more first cells, and the second BMU is configured to collect cell data of the one or more second cells. This embodiment of this application is implemented, so that the first BMU and the second BMU communicate with each other and transmit the cell data, and BMUs of different types of BMICs can be used together in a same battery management system, and system compatibility is better.

According to a fifth aspect, this application an energy storage apparatus. The energy storage apparatus includes a first battery pack, a second battery pack, and the BMS according to the first aspect. The first BMU is configured to collect cell data of a cell in the first battery pack, and the second BMU is configured to collect cell data of a cell in the second battery pack. This embodiment of this application is implemented, so that BMUs of different types of BMICs can be used together in a same energy storage apparatus, and system compatibility is better.

In a possible implementation, the energy storage apparatus further includes a main control unit, and the main control unit is configured to: manage the first battery pack and the second battery pack, and receive cell data reported by each BMU in the first battery pack and the second battery pack. The main control unit includes a first-type communication output port, a first-type communication input port, a second-type communication output port, and a second-type communication input port. The first-type communication output port is connected to a first-type input port of the first BMU, the first-type communication input port is connected to a first-type output port of the second BMU, the second-type communication output port is connected to a second-type input port of the first BMU, and the second-type communication input port is connected to a second-type output port of the second BMU. This embodiment of this application is implemented, so that two types of communication output ports can be disposed inside the main control unit to deliver control instructions to the first BMU and the second BMU, and two types of communication input ports can be disposed inside the main control unit to receive the cell data reported by the first BMU and the second BMU. In this way, the main control unit communicates with the first BMU and the second BMU.

In a possible implementation, a first-type output port of the second BMU is configured to connect to a first-type input port of a third BMU, and a second-type output port of the second BMU is configured to connect to a second-type input port of the third BMU, so that the second BMU communicates with the third BMU. Inside the third BMU, the first-type input port of the third BMU is configured to connect to a first-type output port of the third BMU, and the second-type input port of the third BMU is configured to connect to a third BMIC of the third BMU. The third BMIC and the second BMIC support a same communication protocol. Optionally, the third BMIC and the first BMIC support a same communication protocol. This is not limited herein. This embodiment of this application is implemented, so that the BMUs of the different types of BMICs can be used together in the same energy storage apparatus, and the system compatibility is better.

According to a sixth aspect, this application provides an energy storage system. The energy storage system includes the energy storage apparatus according to the first aspect and any one of the possible implementations of the first aspect, and a power conversion system. The power conversion system is configured to: convert a direct current output by the energy storage apparatus into an alternating current, or convert an alternating current into a direct current and input the direct current to the energy storage apparatus. The direct current output by the energy storage apparatus is obtained by converting, by a direct current converter inside the energy storage apparatus, direct currents output by the first battery pack and the second battery pack. This embodiment of this application is implemented, so that the BMS can intelligently manage and maintain the first battery pack and the second battery pack, to ensure safe and reliable running of the first battery pack and the second battery pack, thereby improving power supply safety and power supply reliability of the energy storage system.

It should be understood that implementation and beneficial effect of the foregoing plurality of aspects of this application may refer to each other.

### BRIEF DESCRIPTION OF DRAWINGS

FIG. 1 is a diagram of a structure of an energy storage system according to an embodiment of this application;
FIG. 2 is a diagram of a structure in which a battery management system uses a wired BMIC according to an embodiment of this application;
FIG. 3A and FIG. 3B are a schematic of a circuit in which a battery management system uses a wired BMIC according to an embodiment of this application;
FIG. 4A and FIG. 4B are a schematic of another circuit in which a battery management system uses a wired BMIC according to an embodiment of this application;
FIG. 5 is a diagram of another structure in which a battery management system uses a wired BMIC according to an embodiment of this application;
FIG. 6 is a diagram of another structure in which a battery management system uses a wired BMIC according to an embodiment of this application;
FIG. 7 is a diagram of another structure in which a battery management system uses a wired BMIC according to an embodiment of this application;
FIG. 8 is a diagram of another structure in which a battery management system uses a wired BMIC according to an embodiment of this application;
FIG. 9 is a diagram of another structure in which a battery management system uses a wired BMIC according to an embodiment of this application;
FIG. 10 is a diagram of another structure in which a battery management system uses a wired BMIC according to an embodiment of this application;
FIG. 11A is a diagram of another structure in which a battery management system uses a wired BMIC according to an embodiment of this application;
FIG. 11B is a diagram of another structure in which a battery management system uses a wired BMIC according to an embodiment of this application;
FIG. 12A is a diagram of a structure in which a battery management system uses a wireless BMIC according to an embodiment of this application; and
FIG. 12B is a diagram of another structure in which a battery management system uses a wireless BMIC according to an embodiment of this application.

### DESCRIPTION OF EMBODIMENTS

The following clearly and completely describes technical solutions in embodiments of this application with reference to accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The technical solutions of this application are further described below in detail with reference to the accompanying drawings.

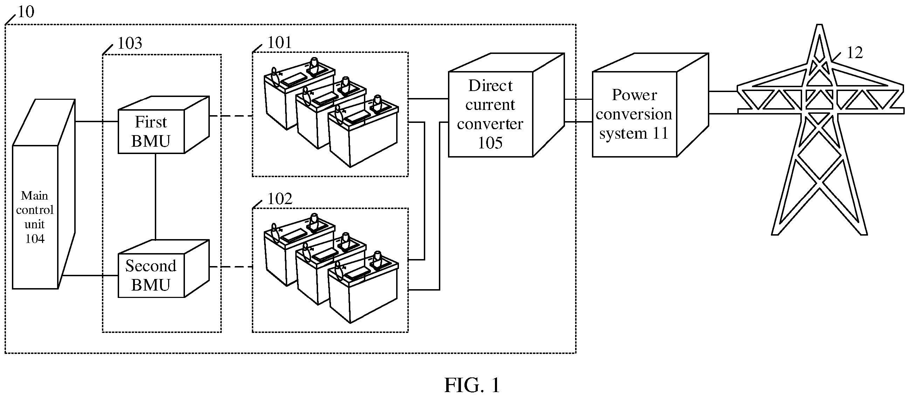

FIG. 1 is a diagram of a structure of an energy storage system according to an embodiment of this application. As shown in FIG. 1, the energy storage system includes an energy storage apparatus 10 and a power conversion system 11. An input end of the power conversion system 11 is connected to an output end of the energy storage apparatus 10, and an output end of the power conversion system 11 is configured to connect to a grid 12. The power conversion system 11 is configured to: convert a direct current output by the energy storage apparatus 10 into an alternating current and supply power to the grid 12, or convert an alternating current output by the grid 12 into a direct current and input the direct current to the energy storage apparatus 10. The direct current output by the energy storage apparatus 10 is obtained by converting, by a direct current converter 105 inside the energy storage apparatus 10, direct currents output by a first battery pack 101 and a second battery pack 102.

The energy storage apparatus 10 includes the first battery pack 101, the second battery pack 102, and a BMS 103. When the BMS 103 includes a first BMU and a second BMU, the first BMU may be disposed inside the first battery pack 101, and the second BMU may be disposed inside the second battery pack 102. The first BMU is configured to collect cell data of a cell in the first battery pack 101, and the second BMU is configured to collect cell data of a cell in the second battery pack 102. The cell data may be referred to as electrochemical performance data. The electrochemical performance data includes at least one of a cell voltage, a cell temperature, a cell charge current, and a cell discharge current. This is not specifically limited herein. It may be understood that, because each of the first battery pack 101 and the second battery pack 102 usually includes a plurality of cells connected in series and in parallel, there may also be a plurality of BMUs inside each battery pack, and each of the plurality of BMUs may collect, via a sampling front end or a sensor, cell data of a cell corresponding to the BMU.

The energy storage apparatus 10 further includes a main control unit 104, and the main control unit 104 is usually referred to as a battery control unit (battery control unit, BCU). The main control unit 104 is configured to manage the first battery pack 101 and the second battery pack 102. In a specific implementation, the first BMU is configured to transmit the cell data of the cell in the first battery pack 101 to the main control unit 104 through a daisy-chain link. The second BMU is configured to transmit the cell data of the cell in the second battery pack 102 to the main control unit 104 through a daisy-chain link. In this case, the main control unit 104 is configured to receive the cell data reported by the first BMU and the second BMU. Optionally, the first BMU is further configured to: process and analyze the cell data of the cell in the first battery pack 101, and transmit an analysis result to the main control unit 104 through the daisy-chain link. The analysis result indicates whether the cell in the first battery pack 101 is faulty. The second BMU is further configured to: process and analyze the cell data of the cell in the second battery pack 102, and transmit an analysis result to the main control unit 104 through the daisy-chain link. The analysis result indicates whether the cell in the second battery pack 102 is faulty. In this case, the main control unit 104 is configured to receive the analysis results reported by the first BMU and the second BMU.

Further, the main control unit 104 is configured to: manage and control charging and discharging of the first battery pack 101 and the second battery pack 102 based on the received cell data or the analysis results reported by the first BMU and the second BMU. The main control unit 104 is further configured to: determine, based on the received cell data or the analysis result, that a battery pack in the first battery pack 101 and the second battery pack 102 is faulty, and deliver a control instruction to a BMU in the battery pack through the daisy-chain link, to bypass the faulty battery pack.

This embodiment of this application is implemented, so that the main control unit 104 can intelligently manage and maintain the first battery pack 101 and the second battery pack 102, to ensure safe and reliable running of the first battery pack 101 and the second battery pack 102, thereby improving power supply safety and power supply reliability of the energy storage system.

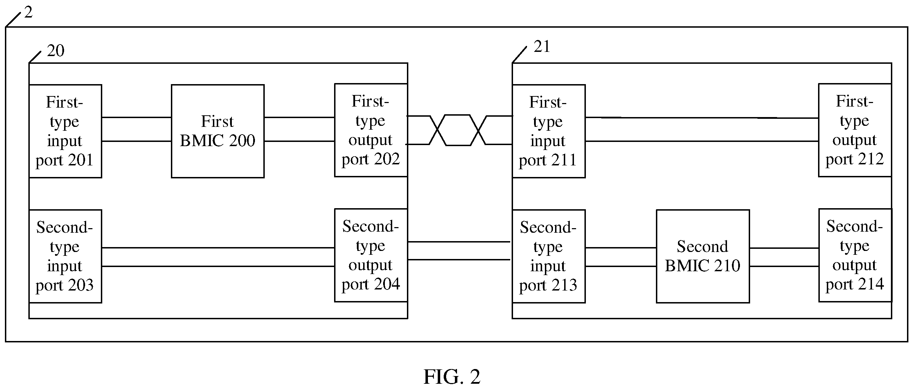

The following describes a battery management system BMS and a working principle thereof provided in this application by using examples with reference to FIG. 2 to FIG. 12B.

FIG. 2 is a diagram of a structure in which a battery management system uses a wired BMIC according to an embodiment of this application. As shown in FIG. 2, a BMS 2 includes a first BMU 20 and a second BMU 21. A communication protocol supported by a first BMIC 200 included in the first BMU 20 is different from a communication protocol supported by a second BMIC 210 included in the second BMU 21. For example, the first BMIC 200 and the second BMIC 210 are BMICs produced by two different manufacturers. The first BMIC 200 and the second BMIC 210 may be any two of an LTC6811 chip, a Max17823 chip, and an MC33771 chip. A communication protocol supported by the LTC6811 chip is an isolated serial peripheral interface (isolated serial peripheral interface, Iso-SPI) protocol, a communication protocol supported by the Max17823 chip is a daisy-chain serial universal asynchronous receiver/transmitter (daisy-chain universal asynchronous receiver/transmitter, Daisy-chain UART) protocol, and a communication protocol supported by the MC33771 chip is an isolated daisy-chain communication protocol (TPL). The foregoing is merely an example. A model of and a communication protocol supported by the BMIC are not limited in embodiments of this application. Each of the first BMU 20 and the second BMU 21 is configured to: manage one or more cells in a battery pack, and collect cell data of the one or more cells in the battery pack. In a specific implementation, the BMIC in each BMU is configured to collect, through a detection port of the BMIC, cell data of each cell corresponding to the BMU. When the cell data is electrochemical performance data, the electrochemical performance data includes at least one of a cell voltage, a cell temperature, a cell charge current, and a cell discharge current. This is not specifically limited herein. The first BMU 20 and the second BMU 21 are located in a same battery pack, and each of the first BMU 20 and the second BMU 21 is configured to manage different cells in the battery pack. Optionally, the first BMU 20 and the second BMU 21 are located in different battery packs, and each of the first BMU 20 and the second BMU 21 is configured to manage one or more cells in the battery packs in which the first BMU 20 and the second BMU 21 are located.

Each of the first BMU 20 and the second BMU 21 includes a first-type input port, a first-type output port, a second-type input port, and a second-type output port. The first-type input port and the second-type input port may also be referred to as daisy-chain differential input pins (pin), and the first-type output port and the second-type output port may also be referred to as daisy-chain differential output pins. For example, the first BMU 20 includes a first-type input port 201, a first-type output port 202, a second-type input port 203, and a second-type output port 204. The second BMU 21 includes a first-type input port 211, a first-type output port 212, a second-type input port 213, and a second-type output port 214. Inside the first BMU 20, the first BMIC 200 is connected between the first-type input port 201 and the first-type output port 202, and the second-type input port 203 is connected to the second-type output port 204. The first-type input port 201, the first-type output port 202, and the first BMIC 200 support a same communication protocol, and the communication protocol is different from a communication protocol supported by the second-type input port 203 and the second-type output port 204. Inside the second BMU 21, the second BMIC 210 is connected between the second-type input port 213 and the second-type output port 214, and the first-type input port 211 is connected to the first-type output port 212. The second-type input port 213, the second-type output port 214, and the second BMIC 210 support a same communication protocol, and the communication protocol is different from a communication protocol supported by the first-type input port 211 and the first-type output port 212. The first-type output port 202 is connected to the first-type input port 211, and the second-type output port 204 is connected to the second-type input port 213, so that the first BMU 20 communicates with the second BMU 21 (for example, daisy-chain communication).

This embodiment of this application is implemented, so that two types of input/output ports can be disposed in each BMU to respectively provide corresponding data transmission channels for the first BMIC 200 and the second BMIC 210. In this way, BMUs of different types of BMICs can be used together in a same battery management system, and system compatibility is better. In addition, when a BMIC in any BMU is faulty, the faulty BMIC may be replaced by using the first BMIC 200 or the second BMIC 210, to ensure reliability of timely supply of the chip and timely replacement of the chip spare part. Moreover, there are no limitations brought by cases in which a single BMIC is short of supply or out of production, and applicability is stronger.

In some feasible implementations, when there are a plurality of BMICs in each BMU, the plurality of BMICs in each BMU are connected in series.

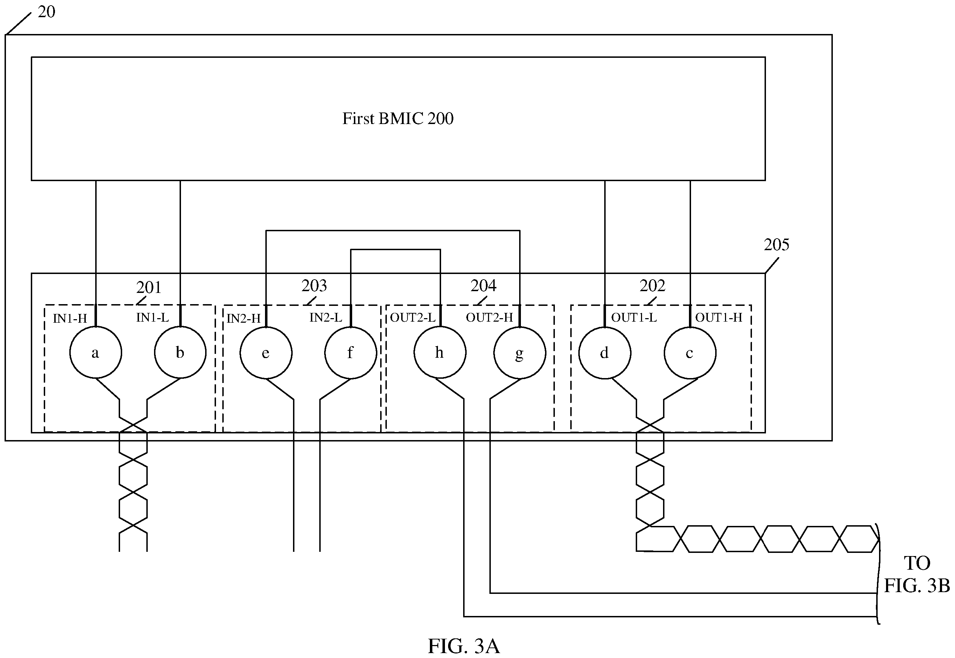

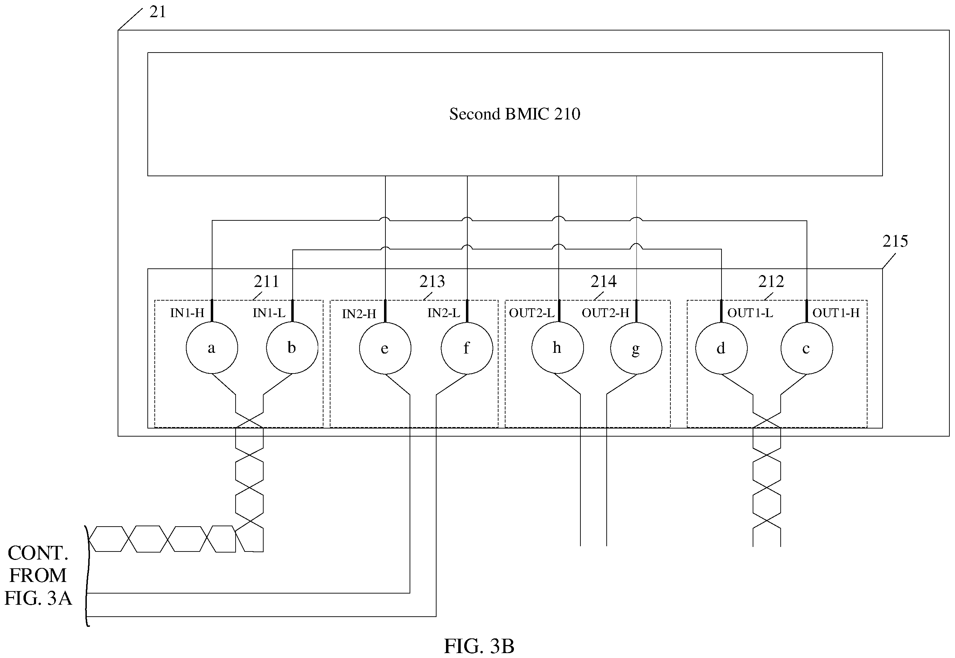

In some feasible implementations, as shown in FIG. 3A and FIG. 3B, the first-type input port shown in FIG. 2 includes a first high-level input port IN1-H and a first low-level input port IN1-L, and the first-type output port includes a first high-level output port OUT1-H and a first low-level output port OUT1-L. The second-type input port shown in FIG. 2 includes a second high-level input port IN2-H and a second low-level input port IN2-L, and the second-type output port includes a second high-level output port OUT2-H and a second low-level output port OUT2-L. Inside the first BMU 20, the first high-level input port IN1-H is connected to the first high-level output port OUT1-H via the first BMIC 200, the first low-level input port IN1-L is connected to the first low-level output port OUT1-L via the first BMIC 200, the second high-level input port IN2-H is connected to the second high-level output port OUT2-H, and the second low-level input port IN2-L is connected to the second low-level output port OUT2-L. Inside the second BMU 21, the first high-level input port IN1-H is connected to the first high-level output port OUT1-H, the first low-level input port IN1-L is connected to the first low-level output port OUT1-L, the second high-level input port IN2-H is connected to the second high-level output port OUT2-H via the second BMIC 210, and the second low-level input port IN2-L is connected to the second low-level output port OUT2-L via the second BMIC 210. This embodiment of this application is implemented, external interfaces of circuit boards of the first BMU 20 and the second BMU 21 can be completely the same, and design sizes of the first BMU 20 and the second BMU 21 can be completely the same, so that physical structure installation of the first BMU 20 and physical structure installation of the second BMU 21 can be completely compatible, and harness connectors of the first BMU 20 and the second BMU 21 can be completely compatible. In addition, after the BMIC in the BMU is faulty, either the first BMIC 200 or the second BMIC 210 may be directly installed and replace the faulty BMIC, and an external cable of the BMIC and an external cable of the BMU do not need to be replaced. Therefore, component replacement costs are lower.

In some feasible implementations, as shown in FIG. 3A and FIG. 3B, the first high-level output port OUT1-H of the first BMU 20 is connected to the first high-level input port IN1-H of the second BMU 21, and the first low-level output port OUT1-L of the first BMU 20 is connected to the first low-level input port IN1-L of the second BMU 21. In addition, the second high-level output port OUT2-H of the first BMU 20 is connected to the second high-level input port IN2-H of the second BMU 21, and the second low-level output port OUT2-L of the first BMU 20 is connected to the second low-level input port IN2-L of the second BMU 21, so that the first BMU 20 and the second BMU 21 perform daisy-chain communication, to transmit a differential signal of the cell data sampled by the BMU.

In some feasible implementations, one harness connector is disposed inside each of the first BMU 20 and the second BMU 21. Specifically, as shown in FIG. 3A and FIG. 3B, the first BMU 20 includes a harness connector 205, and the first-type input port 201, the first-type output port 202, the second-type input port 203, and the second-type output port 204 are all disposed inside the harness connector 205. The second BMU 21 includes a harness connector 215, and the first-type input port 211, the first-type output port 212, the second-type input port 213, and the second-type output port 214 are all disposed inside the harness connector 215.

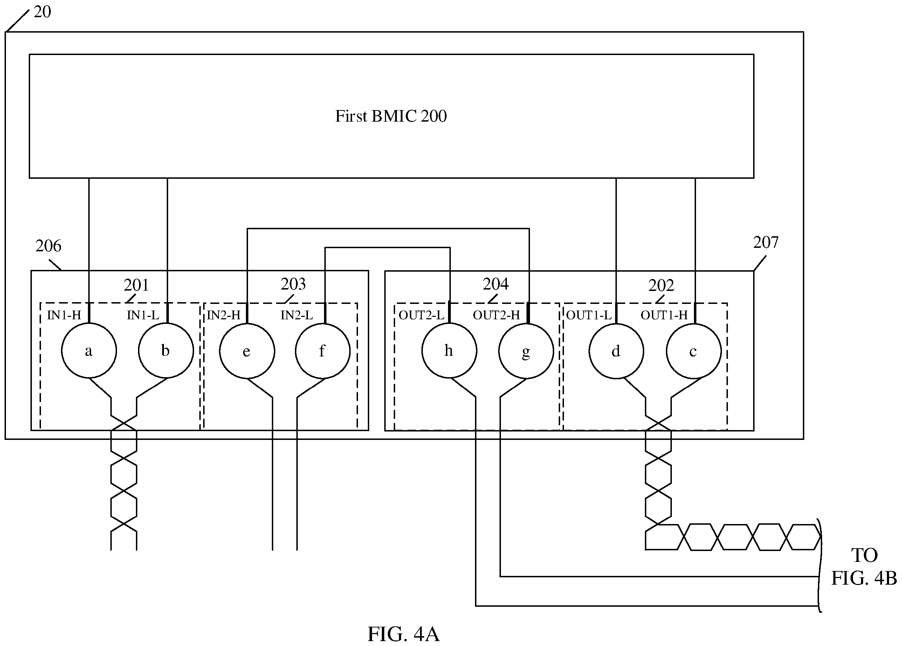

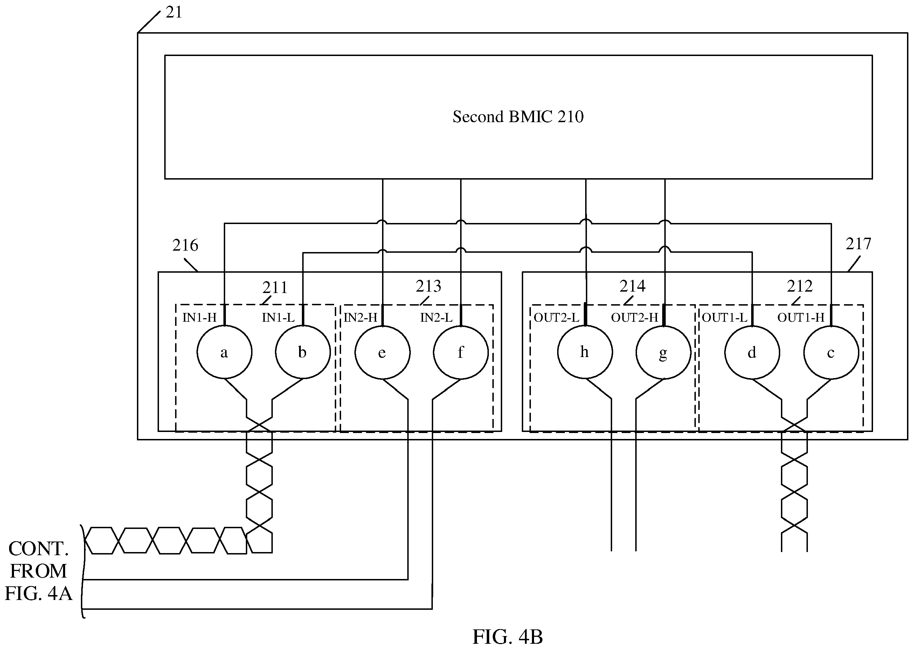

In some feasible implementations, two harness connectors may alternatively be disposed inside each of the first BMU 20 and the second BMU 21. The two harness connectors include an input harness connector and an output harness connector. Specifically, as shown in FIG. 4A and FIG. 4B, the first BMU 20 includes an input harness connector 206 and an output harness connector 207. Both the first-type input port 201 and the second-type input port 203 are disposed inside the input harness connector 206, and both the first-type output port 202 and the second-type output port 204 are disposed inside the output harness connector 207. The second BMU 21 includes an input harness connector 216 and an output harness connector 217. Both the first-type input port 211 and the second-type input port 213 are disposed inside the input harness connector 216, and both the first-type output port 212 and the second-type output port 214 are disposed inside the output harness connector 217.

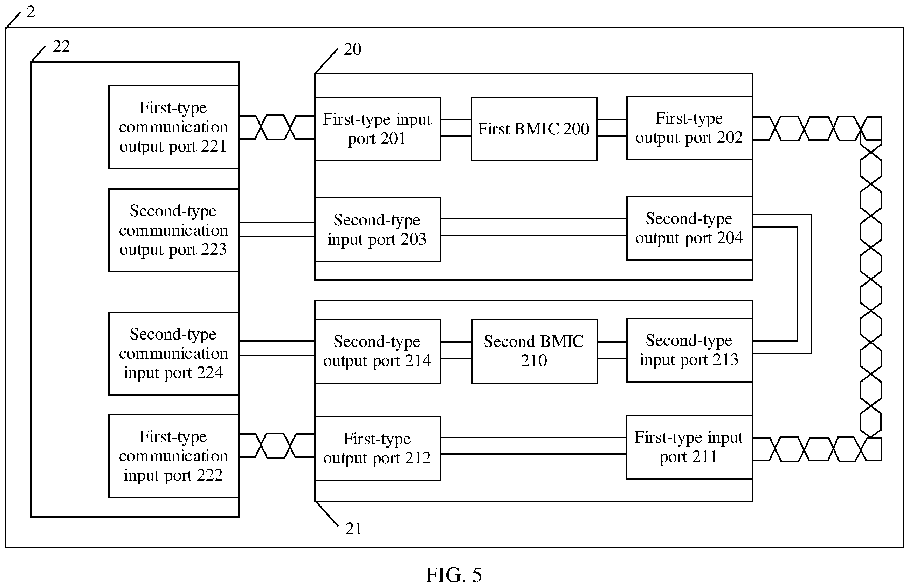

In some feasible implementations, as shown in FIG. 5, the BMS 2 further includes a main control unit 22, and the main control unit 22 is usually referred to as a battery control unit BCU. The main control unit 22 is configured to: manage a plurality of battery packs, and receive cell data reported by each BMU in the plurality of battery packs. The plurality of battery packs include the battery packs in which the first BMU 20 and the second BMU 21 are located, and the battery packs in which the first BMU 20 and the second BMU 21 are located may be a same battery pack, or may be different battery packs. The main control unit 22 includes a first-type communication output port 221, a first-type communication input port 222, a second-type communication output port 223, and a second-type communication input port 224. To implement communication between the main control unit 22 and the BMU, the first-type communication output port 221 is connected to the first-type input port 201 of the first BMU 20, the first-type communication input port 222 is connected to the first-type output port 212 of the second BMU 21, the second-type communication output port 223 is connected to the second-type input port 203 of the first BMU 20, and the second-type communication input port 224 is connected to the second-type output port 214 of the second BMU 21. It may be understood that the first-type communication output port 221, the first-type input port 201, and the first BMIC 200 support a same communication protocol, and the first-type communication input port 222 and the first-type output port 212 of the second BMU 21 support a same communication protocol. The second-type communication output port 223 and the second-type input port 203 of the first BMU 20 support a same communication protocol, and the second-type communication input port 224, the second-type output port 214 of the second BMU 21, and the second BMIC 210 support a same communication protocol.

The first-type communication output port 221 is configured to convert a communication protocol supported by a main processor inside the main control unit 22 into a communication protocol supported by the first-type input port 201, and transmit, to the first BMU 20, a control instruction delivered by the main processor. The first-type communication input port 222 is configured to convert the communication protocol supported by the first-type output port 212 into the communication protocol supported by the main processor inside the main control unit 22, and transmit the cell data or the analysis result of the cell to the main processor. The second-type communication output port 223 is configured to convert the communication protocol supported by the main processor inside the main control unit 22 into the communication protocol supported by the second-type input port 203, and transmit, to the first BMU 20, the control instruction delivered by the main processor. The second-type communication input port 224 is configured to convert a communication protocol supported by the second-type output port 214 into the communication protocol supported by the main processor inside the main control unit 22, and transmit the cell data or the analysis result of the cell to the main processor. For example, the main processor may be a 32-bit microprocessor or a 16-bit microprocessor, and the communication protocol supported by the main processor may be a serial communication protocol.

This embodiment of this application is implemented, so that two types of communication output ports can be disposed inside the main control unit 22 to deliver control instructions to the first BMU 20 and the second BMU 21, and two types of communication input ports can be disposed inside the main control unit 22 to receive the differential signals of the cell data reported by the first BMU 20 and the second BMU 21. In this way, the main control unit 22 communicates with the first BMU 20 and the second BMU 21.

In some feasible implementations, when the BMS 2 includes a plurality of BMUs, and the plurality of BMUs include the first BMU 20 and the second BMU 21, each of the plurality of BMUs includes a plurality of types of input ports and a plurality of types of output ports that one-to-one correspond to the plurality of types of input ports. The plurality of types of input ports include the first-type input port and the second-type input port, and the plurality of types of output ports include the first-type output port and the second-type output port. The plurality of types of input ports and the plurality of types of output ports are collectively referred to as a plurality of types of input/output ports. Communication protocols supported by the plurality of types of input/output ports are the same as communication protocols supported by a plurality of types of BMICs, and the plurality of types of input/output ports one-to-one correspond to the plurality of types of BMICs. Different types of input/output ports support different communication protocols. The plurality of types of BMICs include the first BMIC 200 and the second BMIC 210. In addition, the BMIC is disposed between only one type of input/output ports in the plurality of types of input/output ports, and no BMIC is disposed between input/output ports other than this type of input/output ports. In each BMU, a communication branch that is between the other type of input/output ports and on which no BMIC is disposed is a communication bypass, and is configured to transmit cell data sampled by a BMIC other than the first BMIC 200 or the second BMIC 210 in the plurality of types of BMICs. This embodiment of this application is implemented, so that when a BMIC in each BMU is faulty, the faulty BMIC may be replaced by using any one of the plurality of types of BMICs, to ensure the reliability of the timely supply of the chip and the timely replacement of the chip spare part. Moreover, there are no limitations brought by the cases in which the single BMIC is short of supply or out of production, and the applicability is stronger.

In some feasible implementations, when each BMU includes the plurality of types of input/output ports, the main control unit 22 includes a plurality of types of communication output ports and a plurality of types of communication input ports. The plurality of types of communication output ports and the plurality of types of communication input ports are collectively referred to as a plurality of types of communication output/input ports, and the plurality of types of communication output/input ports one-to-one correspond to the plurality of types of input/output ports. Each of the plurality of types of communication output/input ports supports a same communication protocol as a type of input/output ports corresponding to the type of communication output/input ports, and different types of communication output/input ports support different communication protocols.

In some feasible implementations, when the BMS 2 includes the plurality of BMUs, and the plurality of BMUs include the first BMU 20 and the second BMU 21, a structure of each of the plurality of BMUs may be the same as the structure of the first BMU 20 or the second BMU 21. Details are not described herein again. Each of the plurality of BMUs is configured to manage one or more cells in a battery pack, and collect cell data of the one or more cells in the battery pack in which each BMU is located. For details, refer to the foregoing descriptions of collecting the cell data by the first BMU 20 or the second BMU 21. Details are not described herein again. It may be understood that, for a connection manner between a first BMU in the plurality of BMUs and the main control unit 22, refer to the foregoing descriptions of the connection manner between the first BMU 20 and the main control unit 22. Details are not described herein again. For a connection manner between two adjacent BMUs in the plurality of BMUs, refer to the foregoing descriptions of the connection manner between the first BMU 20 and the second BMU 21. Details are not described herein again. For a connection manner between a last BMU in the plurality of BMUs and the main control unit 22, refer to the foregoing descriptions of the connection manner between the second BMU 21 and the main control unit 22. Details are not described herein again.

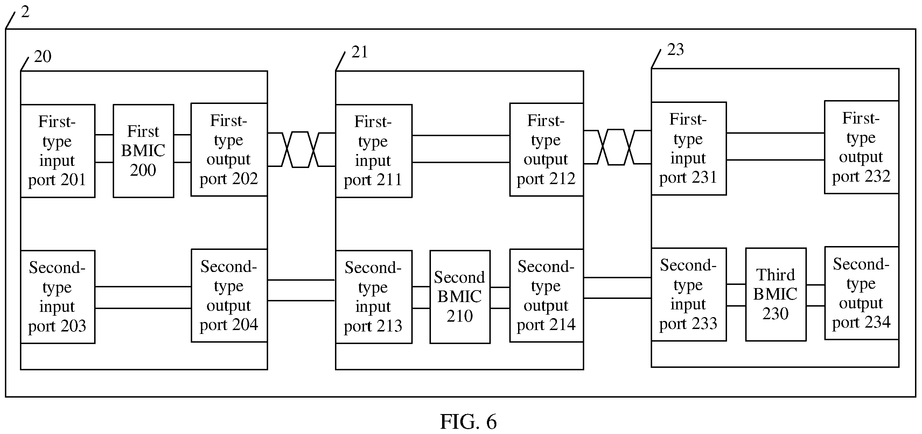

In some feasible implementations, the output port side of the second BMU 21 may further continue to be connected to a third BMU 23. A structure of the third BMU 23 may be the same as the structure of the first BMU 20, or may be the same as the structure of the second BMU 21. When the structure of the third BMU 23 is the same as the structure of the second BMU 21, specifically, as shown in FIG. 6, the third BMU 23 includes a first-type input port 231, a first-type output port 232, a second-type input port 233, a second-type output port 234, and a third BMIC 230. The first-type output port 212 of the second BMU 21 is configured to connect to the first-type input port 231, and the second-type output port 214 of the second BMU 21 is configured to connect to the second-type input port 233, so that the second BMU 21 communicates with the third BMU 23. Inside the third BMU 23, the first-type input port 231 is configured to connect to the first-type output port 232, and the second-type input port 233 is configured to connect to the second-type output port 234 via the third BMIC 230. The third BMIC 230 and the second BMIC 210 support a same communication protocol. This embodiment of this application is implemented, so that the BMUs of the plurality of different types of BMICs can be used together in the same battery management system, and the system compatibility is better.

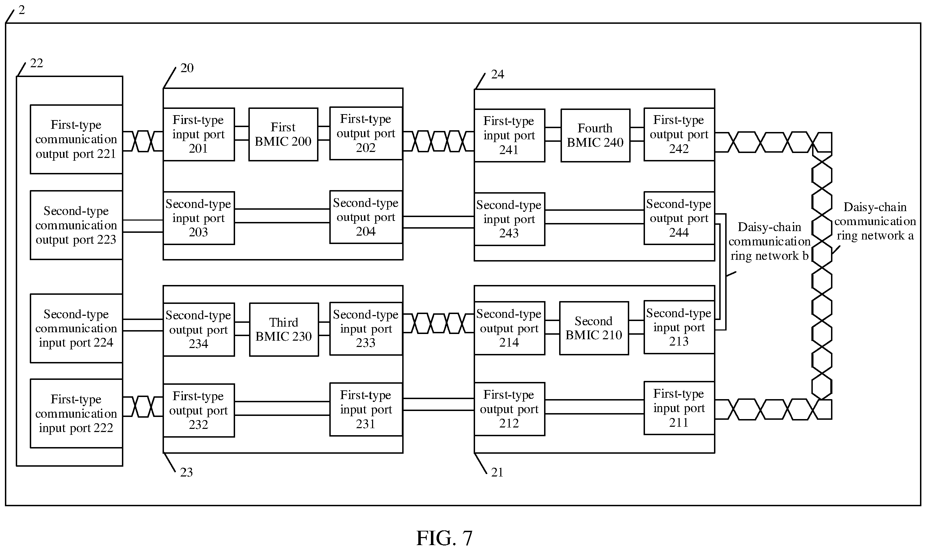

In some feasible implementations, a fourth BMU 24 is further connected between the output port side of the first BMU 20 and the input port side of the second BMU 21. A structure of the fourth BMU 24 may be the same as the structure of the first BMU 20, or may be the same as the structure of the second BMU 21. When the structure of the fourth BMU 24 is the same as the structure of the first BMU 20, specifically, as shown in FIG. 7, the fourth BMU 24 includes a first-type input port 241, a first-type output port 242, a second-type input port 243, a second-type output port 244, and a fourth BMIC 240. The first-type output port 202 is configured to connect to the first-type input port 241, and the second-type output port 204 is configured to connect to the second-type input port 243, so that the first BMU 20 communicates with the fourth BMU 24. Inside the fourth BMU 24, the first-type input port 241 is configured to connect to the first-type output port 242 via the fourth BMIC 240, and the second-type input port 243 is connected to the second-type output port 244. The fourth BMIC 240 and the first BMIC 200 support a same communication protocol. The first-type output port 242 is connected to the first-type input port 211, and the second-type output port 244 is connected to the second-type input port 213, so that the fourth BMU 24 communicates with the second BMU 21. To implement communication between the main control unit 22 and the BMU, the first-type input port 201 is connected to the first-type communication output port 221, the first-type output port 232 is connected to the first-type communication input port 222, the second-type input port 203 is connected to the second-type communication output port 223, and the second-type output port 244 is connected to the second-type communication input port 224. The first-type communication output port 221, the first-type input port 201, and the first BMIC 200 support the same communication protocol, and the first-type communication input port 222 and the first-type output port 232 support a same communication protocol. The second-type communication output port 223 and the second-type input port 203 support the same communication protocol, and the second-type communication input port 224, the second-type output port 234, and the third BMIC 230 support a same communication protocol.

It may be understood that, in FIG. 7, the first-type input port and the first-type output port of the first BMU 20, the second BMU 21, the third BMU 23, and the fourth BMU 24 are connected hand in hand over a daisy-chain communication ring network a, and a head and a tail of the daisy-chain communication ring network a are respectively connected to the first-type communication output port 221 and the first-type communication input port 222. The hand-in-hand connection is a system cabling architecture in which more than three BMUs are connected by using one cable (for example, a twisted pair), and one of the more than three BMUs is connected only to a next BMU adjacent to the BMU. The second-type input port and the second-type output port of the first BMU 20, the second BMU 21, the third BMU 23, and the fourth BMU 24 are connected hand in hand over a daisy-chain communication ring network b. A head and a tail of the daisy-chain communication ring network b are respectively connected to the second-type communication output port 223 and the second-type communication input port 224.

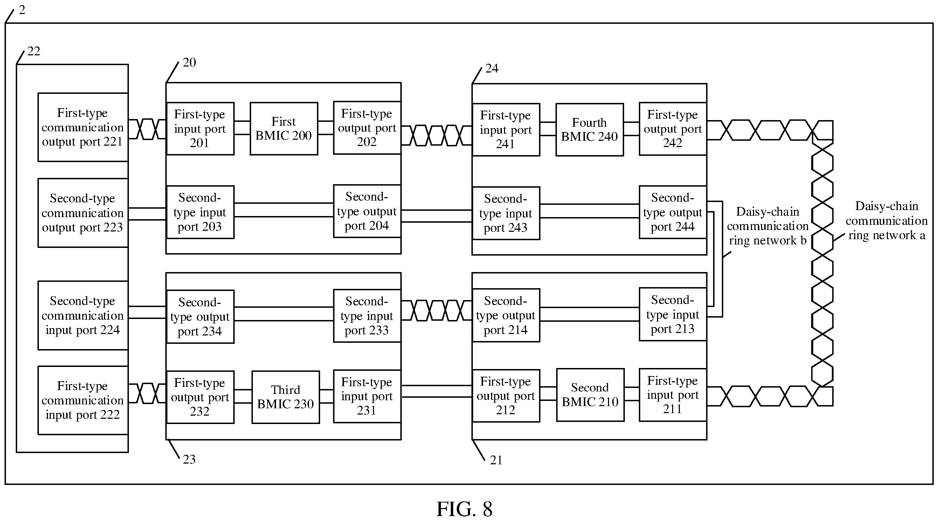

In some feasible implementations, when the structures of the second BMU 21 and the third BMU 23 shown in FIG. 7 are the same as the structure of the first BMU 20, specifically, as shown in FIG. 8, the second BMIC 210 is connected between the first-type input port 211 and the first-type output port 212, the second BMIC 210, the first-type input port 211, and the first-type output port 212 support a same communication protocol, and the communication protocol is different from a communication protocol supported by the second-type input port 213 and the second-type output port 214. The third BMIC 230 is connected between the first-type input port 231 and the first-type output port 232. In this case, the third BMIC 230, the first-type input port 231, and the first-type output port 232 support a same communication protocol, and the communication protocol is different from a communication protocol supported by the second-type input port 233 and the second-type output port 234.

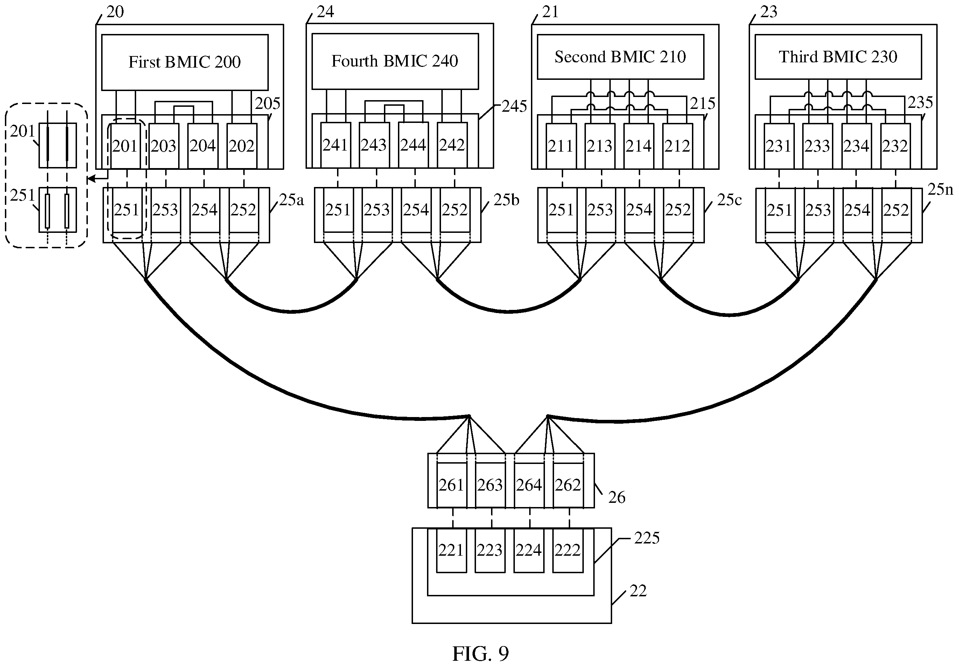

In some feasible implementations, when one harness connector is disposed inside each BMU, a plug corresponding to the harness connector of each BMU is further disposed in the BMS 2. Specifically, as shown in FIG. 9, the first-type input port 201, the first-type output port 202, the second-type input port 203, and the second-type output port 204 shown in FIG. 7 are all disposed inside the harness connector 205 in the first BMU 20. The first-type input port 241, the first-type output port 242, the second-type input port 243, and the second-type output port 244 are all disposed inside a harness connector 245 in the fourth BMU 24. The first-type input port 211, the first-type output port 212, the second-type input port 213, and the second-type output port 214 are all disposed inside the harness connector 215 in the second BMU 21. The first-type input port 231, the first-type output port 232, the second-type input port 233, and the second-type output port 204 are all disposed inside a harness connector 235 in the third BMU 23. The BMS 2 further includes a plug 25a, a plug 25b, a plug 25c, and a plug 25n. The plug 25a is plugged into the harness connector 205, the plug 25b is plugged into the harness connector 245, the plug 25c is plugged into the harness connector 215, and the plug 25n is plugged into the harness connector 235.

An example in which the plug 25a is plugged into the harness connector 205 is used for description. The plug 25a includes a first-type input plug port 251, a first-type output plug port 252, a second-type input plug port 253, and a second-type output plug port 254. The first-type input plug port 251 is plugged into the first-type input port 201. In a specific implementation, as shown in an enlarged view in a dashed-line box in FIG. 9, the first-type input plug port 251 includes a first-type high-level input plug port and a first-type low-level input plug port. The first-type high-level input plug port is plugged into the first high-level input port IN1-H in the first-type input port 201, and a plugged contact may be a contact a in the harness connector 205 shown in FIG. 3A and FIG. 3B. The first-type low-level input plug port is plugged into the first-type low-level input port IN1-L in the first-type input port 201, and a plugged contact may be a contact b in the harness connector 205 shown in FIG. 3A and FIG. 3B. The first-type output plug port 252 is plugged into the first-type output port 202, and two plugged contacts may be a contact c and a contact d in the harness connector 205 shown in FIG. 3A and FIG. 3B. The second-type input plug port 253 is plugged into the second-type input port 203, and two plugged contacts may be a contact e and a contact f in the harness connector 205 shown in FIG. 3A and FIG. 3B. The second-type output plug port 254 is plugged into the second-type output port 204, and two plugged contacts may be a contact g and a contact h in the harness connector 205 shown in FIG. 3A and FIG. 3B. It should be understood that, for a structure of another plug in the plug 25a, the plug 25b, the plug 25c, and the plug 25n and a plugging manner between the plug and a corresponding harness connector, refer to the foregoing specific descriptions of the structure of the plug 25a and plugging between the plug 25a and the harness connector 205. Details are not described herein again.

This embodiment of this application is implemented, so that a reliable connection can be provided for the BMU by plugging the harness connector in each BMU into the plug corresponding to the harness connector, to ensure that the BMU does not fall off due to movement, vibration, or the like, and the BMIC in the BMU can be quickly and flexibly replaced to adapt to different application requirements of the BMU, thereby improving flexibility and reliability of using the BMU. In addition, a user can quickly and conveniently connect and disconnect a circuit between the harness connector in each BMU and the plug corresponding to the harness connector, thereby improving user experience.

In some feasible implementations, when the first-type input port, the first-type output port, the second-type input port, and the second-type output port of each BMU are all pins, the first-type input plug port, the first-type output plug port, the second-type input plug port, and the second-type output plug port in the plug corresponding to the BMU are all jacks. Optionally, when the first-type input port, the first-type output port, the second-type input port, and the second-type output port of each BMU are all jacks, the first-type input plug port, the first-type output plug port, the second-type input plug port, and the second-type output plug port in the plug corresponding to the BMU are all pins. The foregoing is merely an example. A specific form of the port is not limited in embodiments of this application.

In some feasible implementations, when one harness connector is disposed inside the main control unit 22, as shown in FIG. 9, the first-type communication output port 221, the first-type communication input port 222, the second-type communication output port 223, and the second-type communication input port 224 are all disposed inside a harness connector 225 in the main control unit 22. In this case, the BMS 2 further includes a plug 26. The plug 26 includes a first-type communication output plug port 261, a first-type communication input plug port 262, a second-type communication output plug port 263, and a second-type communication input plug port 264. The first-type communication output plug port 261 is plugged into the first-type communication output port 221, the first-type communication input plug port 262 is plugged into the first-type communication input port 222, the second-type communication output plug port 263 is plugged into the second-type communication output port 223, and the second-type communication input plug port 264 is plugged into the second-type communication input port 224, so that the plug 26 is plugged into the harness connector 225. It should be understood that, for a structure of each port in the plug 26 and each port in the harness connector 225 and a specific plugging manner between the port in the plug 26 and the port in the harness connector 225, refer to the foregoing descriptions of the structures of the first-type input plug port 251 and the first-type input port 201 and the specific plugging manner between the first-type input plug port 251 and the first-type input port 201. Details are not described herein again. This embodiment of this application is implemented, so that a reliable connection can be provided for the main control unit 22 by plugging the plug 26 into the harness connector 225, to ensure that the main control unit 22 does not fall off due to movement, vibration, or the like, thereby improving connection reliability of the main control unit 22. In addition, the user can quickly and conveniently connect and disconnect a circuit between the plug 26 and the harness connector 225, thereby improving user experience.

In some feasible implementations, when the first-type communication output port 221, the first-type communication input port 222, the second-type communication output port 223, and the second-type communication input port 224 are all pins, the first-type communication output plug port 261, the first-type communication input plug port 262, the second-type communication output plug port 263, and the second-type communication input plug port 264 are all jacks. Optionally, when the first-type communication output port 221, the first-type communication input port 222, the second-type communication output port 223, and the second-type communication input port 224 are all jacks, the first-type communication output plug port 261, the first-type communication input plug port 262, the second-type communication output plug port 263, and the second-type communication input plug port 264 are all pins. The foregoing is merely an example. A specific form of the port is not limited in embodiments of this application.

In some feasible implementations, connection relationships between the plug 25a, the plug 25b, the plug 25c, the plug 25n, and the plug 26 are shown in FIG. 9. The first-type input plug port 251 in the plug 25a is configured to connect to the first-type communication output plug port 261 in the plug 26, and the second-type input plug port 253 in the plug 25a is configured to connect to the second-type communication output plug port 263 in the plug 26, so that the main control unit 22 communicates with the first BMU 20 to deliver the control instruction. The first-type output plug port 252 in the plug 25a is configured to connect to the first-type input plug port 251 in the plug 25b, and the second-type output plug port 254 in the plug 25a is configured to connect to the second-type input plug port 253 in the plug 25b, so that the first BMU 20 communicates with the fourth BMU 24. The first-type output plug port 252 in the plug 25b is configured to connect to the first-type input plug port 251 in the plug 25c, and the second-type output plug port 254 in the plug 25b is configured to connect to the second-type input plug port 253 in the plug 25c, so that the fourth BMU 24 communicates with the second BMU 21. The first-type output plug port 252 in the plug 25c is configured to connect to the first-type input plug port 251 in the plug 25n, and the second-type output plug port 254 in the plug 25c is configured to connect to the second-type input plug port 253 in the plug 25n, so that the second BMU 21 communicates with the third BMU 23. The first-type output plug port 252 in the plug 25n is configured to connect to the first-type communication input plug port 262 in the plug 26, and the second-type output plug port 254 in the plug 25n is configured to connect to the second-type communication input plug port 264 in the plug 26, so that the third BMU 23 communicates with the main control unit 22.

It may be understood that connections between the ports of the plug 25a, the plug 25b, the plug 25c, the plug 25n, and the plug 26 may be implemented by using one multi-core cable bundle or a plurality of single-core cable bundles. As shown in FIG. 9, the connections between the ports of the plugs may be implemented by using the multi-core cable bundle.

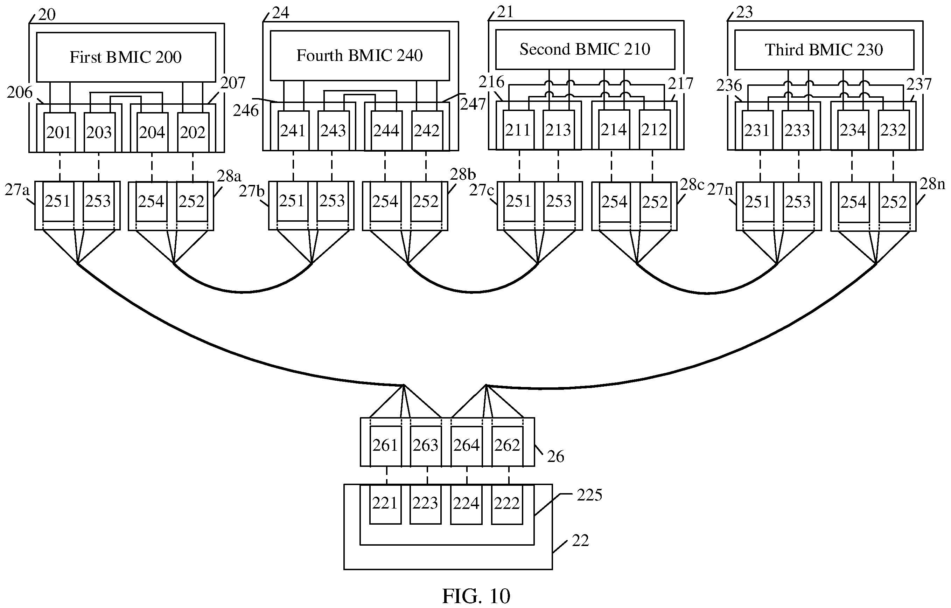

In some feasible implementations, when an input harness connector and an output harness connector are disposed inside each BMU, an input plug corresponding to the input harness connector of each BMU and an output plug corresponding to the output harness connector of each BMU are further disposed in the BMS 2. Specifically, as shown in FIG. 10, both the first-type input port 201 and the second-type input port 203 shown in FIG. 7 are disposed in the input harness connector 206 in the first BMU 20, and both the first-type output port 202 and the second-type output port 204 are disposed in the output harness connector 207 in the first BMU 20. Both the first-type input port 241 and the second-type input port 243 are disposed inside an input harness connector 246 in the fourth BMU 24, and both the first-type output port 242 and the second-type output port 244 are disposed inside an output harness connector 247 in the fourth BMU 24. Both the first-type input port 211 and the second-type input port 213 are disposed inside the input harness connector 216 in the second BMU 21, and both the first-type output port 212 and the second-type output port 214 are disposed inside the output harness connector 217 in the second BMU 21. Both the first-type input port 231 and the second-type input port 233 are disposed inside an input harness connector 236 in the third BMU 23, and both the first-type output port 232 and the second-type output port 204 are disposed inside an output harness connector 237 in the third BMU 23.

The BMS 2 further includes an input plug 27a, an input plug 27b, an input plug 27c, and an input plug 27n. The input plug 27a is plugged into the input harness connector 206, the input plug 27b is plugged into the input harness connector 246, the input plug 27c is plugged into the input harness connector 216, and the input plug 27n is plugged into the input harness connector 236. An example in which the input plug 27a is plugged into the input harness connector 206 is used for description. The input plug 27a includes the first-type input plug port 251 and the second-type input plug port 253. The first-type input plug port 251 is plugged into the first-type input port 201, the second-type input plug port 253 is plugged into the second-type input port 203, so that the input plug 27a is plugged into the input harness connector 206. It may be understood that, for a structure of another plug in the input plug 27a, the input plug 27b, the input plug 27c, and the input plug 27n and a plugging manner between the plug and a corresponding input harness connector, refer to the foregoing related descriptions of the structure of the input plug 27a and plugging between the input plug 27a and the input harness connector 206. Details are not described herein again.

The BMS 2 further includes an output plug 28a, an output plug 28b, an output plug 28c, and an output plug 28n. The output plug 28a is plugged into the output harness connector 207, the output plug 28b is plugged into the output harness connector 247, the output plug 28c is plugged into the output harness connector 217, and the output plug 28n is plugged into the output harness connector 237. An example in which the output plug 28a is plugged into the output harness connector 207 is used for description. The output plug 28a includes the first-type output plug port 252 and the second-type output plug port 254. The first-type output plug port 252 is plugged into the first-type output port 202, the second-type output plug port 254 is plugged into the second-type output port 204, so that the output plug 28a is plugged into the output harness connector 207. It may be understood that, for a structure of another plug in the output plug 28a, the output plug 28b, the output plug 28c, and the output plug 28n and a plugging manner between the plug and a corresponding output harness connector, refer to the foregoing related descriptions of the structure of the output plug 28a and plugging between the output plug 28a and the output harness connector 207. Details are not described herein again.

This embodiment of this application is implemented, so that the reliable connection can be provided for the BMU by plugging the input plug into the input harness connector corresponding to the input plug and plugging the output plug into the output harness connector corresponding to the output plug, to ensure that the BMU does not fall off due to movement, vibration, or the like, and the BMIC in the BMU can be quickly and flexibly replaced to adapt to different application requirements of the BMU, thereby improving the flexibility and the reliability of using the BMU. In addition, the user can quickly and conveniently connect and disconnect a circuit between the input plug and the input harness connector corresponding to the input plug, and a circuit between the output plug and the output harness connector corresponding to the output plug, thereby improving user experience.

In some feasible implementations, connection relationships between the input plug 27a to the input plug 27n, the output plug 28a to the output plug 28n, and the plug 26 are shown in FIG. 10. The first-type input plug port 251 in the input plug 27a is configured to connect to the first-type communication output plug port 261 in the plug 26, and the second-type input plug port 253 in the input plug 27a is configured to connect to the second-type communication output plug port 263 in the plug 26, so that the main control unit 22 communicates with the first BMU 20 to deliver the control instruction. The first-type output plug port 252 in the output plug 28a is configured to connect to the first-type input plug port 251 in the input plug 27b, and the second-type output plug port 254 in the output plug 28a is configured to connect to the second-type input plug port 253 in the input plug 27b, so that the first BMU 20 communicates with the fourth BMU 24. The first-type output plug port 252 in the output plug 28b is configured to connect to the first-type input plug port 251 in the input plug 27c, and the second-type output plug port 254 in the output plug 28b is configured to connect to the second-type input plug port 253 in the input plug 27c, so that the fourth BMU 24 communicates with the second BMU 21. The first-type output plug port 252 in the output plug 28c is configured to connect to the first-type input plug port 251 in the input plug 27n, and the second-type output plug port 254 in the output plug 28c is configured to connect to the second-type input plug port 253 in the input plug 27n, so that the second BMU 21 communicates with the third BMU 23. The first-type output plug port 252 in the output plug 28n is configured to connect to the first-type communication input plug port 262 in the plug 26, and the second-type output plug port 254 in the output plug 28n is configured to connect to the second-type communication input plug port 264 in the plug 26, so that the third BMU 23 communicates with the main control unit 22.

It may be understood that connections between the ports of the input plug 27a to the input plug 27n, the output plug 28a to the output plug 28n, and the plug 26 may be implemented by using one multi-core cable bundle or a plurality of single-core cable bundles. As shown in FIG. 10, the connections between the ports of the plugs may be implemented by using the multi-core cable bundle.

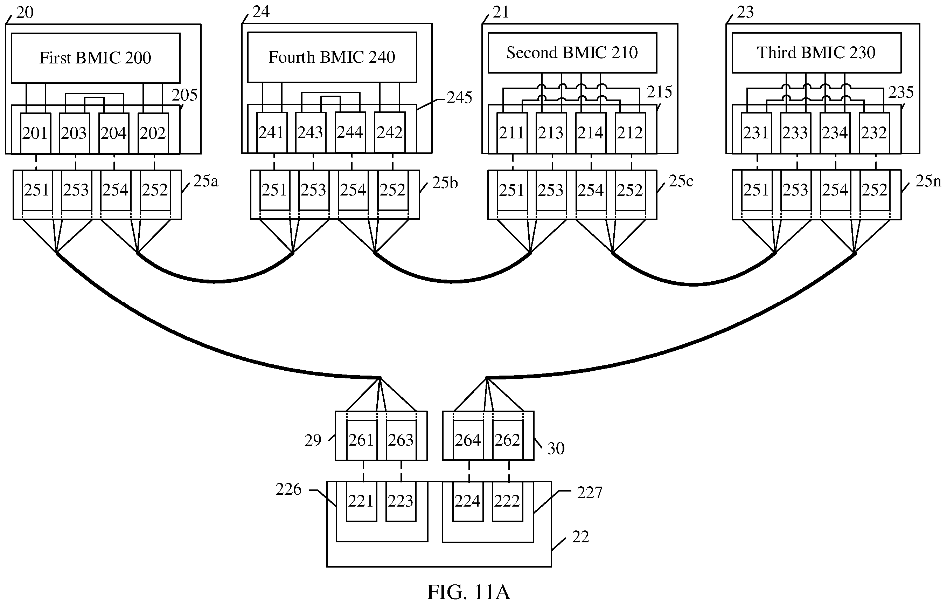

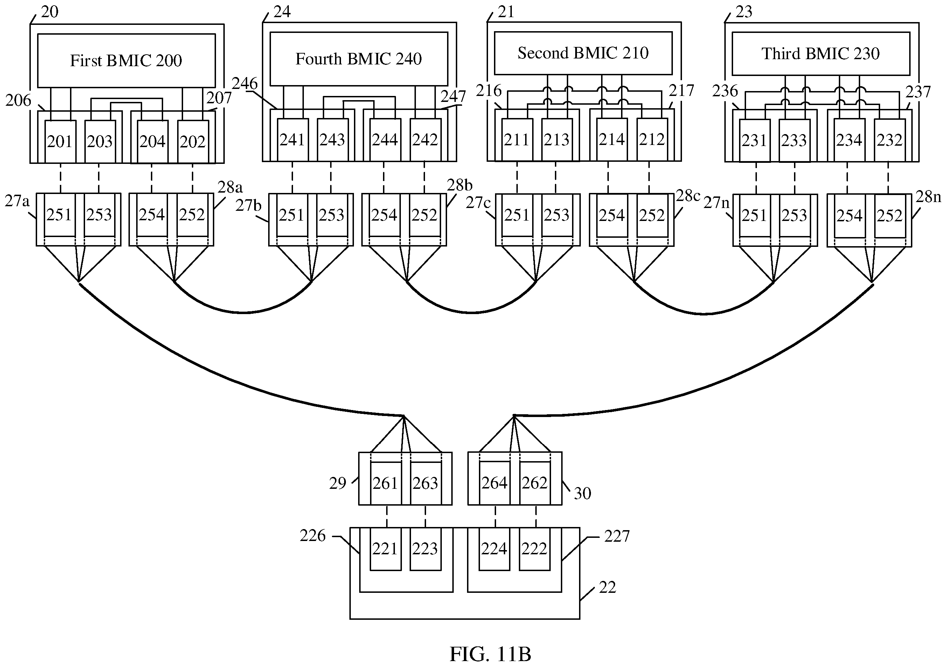

In some feasible implementations, when the harness connector 225 shown in FIG. 9 is replaced with an output harness connector 226 and an input harness connector 227, and the plug 26 is replaced with an output plug 29 and an input plug 30, the structure of the BMS 2 may be shown in FIG. 11A. When the harness connector 225 shown in FIG. 10 is replaced with the output harness connector 226 and the input harness connector 227, and the plug 26 is replaced with the output plug 29 and the input plug 30, the structure of the BMS 2 may be shown in FIG. 11B. In FIG. 11A and FIG. 11B, both the first-type communication output port 221 and the second-type communication output port 223 are disposed inside the output harness connector 226 in the main control unit 22, and both the first-type communication input port 222 and the second-type communication input port 224 are disposed inside the input harness connector 227 in the main control unit 22. In this case, the BMS 2 further includes the output plug 29 and the input plug 30. The output plug 29 includes the first-type communication output plug port 261 and the second-type communication output plug port 263. The input plug 30 includes the first-type communication input plug port 262 and the second-type communication input plug port 264. The first-type communication output plug port 261 is plugged into the first-type communication output port 221, and the second-type communication output plug port 263 is plugged into the second-type communication output port 223, so that the output plug 29 is plugged into the output harness connector 226. The first-type communication input plug port 262 is plugged into the first-type communication input port 222, and the second-type communication input plug port 264 is plugged into the second-type communication input port 224, so that the input plug 30 is plugged into the input harness connector 227.

This embodiment of this application is implemented, so that the reliable connection can be provided for the main control unit 22 by plugging the output plug 29 into the output harness connector 226 and plugging the input plug 30 into the input harness connector 227, to ensure that the main control unit 22 does not fall off due to movement, vibration, or the like, thereby improving the connection reliability of the main control unit 22. In addition, the user can quickly and conveniently connect and disconnect a circuit between the output plug 29 and the output harness connector 226, and a circuit between the input plug 30 and the input harness connector 227, thereby improving user experience.

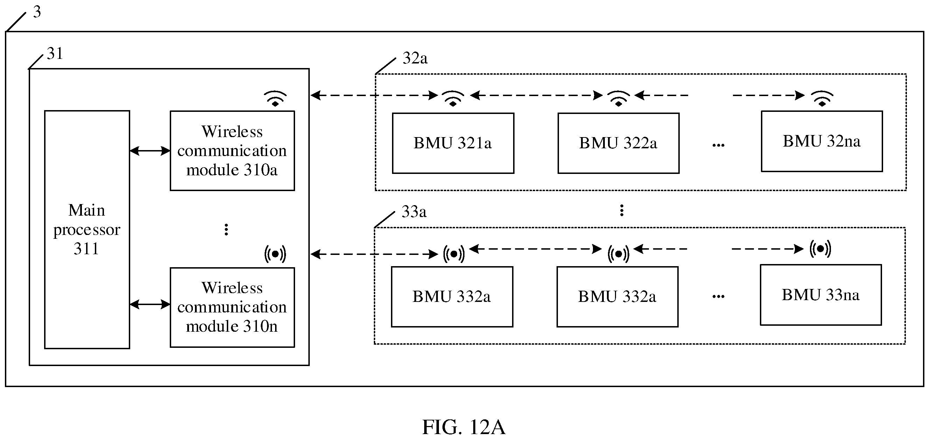

FIG. 12A is a diagram of a structure in which a battery management system uses a wireless BMIC according to an embodiment of this application. As shown in FIG. 12A, a BMS 3 includes a main control unit 31 and a wireless communication link 32a to a wireless communication link 33a. Any two of the wireless communication link 32a to the wireless communication link 33a use different communication protocols. In other words, at least two communication protocols are used for the wireless communication link 32a to the wireless communication link 33a, the at least two communication protocols may be communication protocols used by at least two wireless BMICs, and the communication protocols one-to-one correspond to the wireless BMICs. For example, the at least two communication protocols include a low power wide area network (low power wide area network, LPWAN) communication protocol (long range, LoRa), a narrowband internet of things (narrowband internet of things, NB-LOT) communication protocol, a wireless fidelity (wireless fidelity, Wi-Fi) communication protocol, and Bluetooth. There may be one or more links of each of the wireless communication link 32a to the wireless communication link 33a. When there are the plurality of links of each wireless communication link, communication protocols used by the plurality of wireless communication links are a same communication protocol. For example, in FIG. 12A, there is one link of each wireless communication link. The foregoing is merely an example. This is not specifically limited in embodiments of this application.

The main control unit 31 includes a wireless communication module 310a to a wireless communication module 310n that one-to-one correspond to the wireless communication link 32a to the wireless communication link 33a. For example, the wireless communication module 310a corresponds to the wireless communication link 32a, ..., and the wireless communication module 310n corresponds to the wireless communication link 33a.

Each of the wireless communication link 32a to the wireless communication link 33a includes one or more BMUs. When each wireless communication link includes the plurality of BMUs, a BMU that is in the plurality of BMUs and that is closest to the wireless communication module corresponding to each wireless communication link performs wireless communication with the wireless communication module corresponding to each wireless communication link, and two adjacent BMUs in the plurality of BMUs perform wireless communication.

For example, the wireless communication link 32a includes a BMU 321a to a BMU 32na. The BMU 321a directly performs wireless communication with the wireless communication module 310a, and wireless communication is performed between two adjacent BMUs in the BMU 321a to the BMU 32na. In a specific implementation, each of the BMU 321a to the BMU 32na includes a wireless battery management integrated circuit BMIC and a wireless communication module. The wireless communication module inside the BMU 321a is configured to perform wireless communication with the wireless communication module 310a, to receive an instruction delivered by a main processor 311 in the main control unit 31, or send, to the main processor 311, a battery parameter collected by the wireless BMIC inside the BMU 321a. Wireless communication is performed between wireless communication modules inside two adjacent BMUs in the BMU 321a to the BMU 32na, to transmit the battery parameter collected by the wireless BMIC or the instruction delivered by the main processor 311. For example, the wireless communication link 33a includes a BMU 332a to a BMU 33na. The BMU 332a directly performs wireless communication with the wireless communication module 310n, and wireless communication is performed between two adjacent BMUs in the BMU 332a to the BMU 33na. For a specific process in which the BMU 332a performs wireless communication with the wireless communication module 310n and a specific process in which two adjacent BMUs perform wireless communication, refer to the foregoing related descriptions in which the BMU 321a performs wireless communication with the wireless communication module 310a and the two adjacent BMUs perform wireless communication. Details are not described herein again.

This embodiment of this application is implemented, so that the wireless communication link 32a to the wireless communication link 33a can use the communication protocols of the at least two wireless BMICs. Therefore, the wireless communication link 32a to the wireless communication link 33a can use BMUs of the at least two wireless BMICs, so that BMUs of different types of wireless BMICs can be used together in a same battery management system, and system compatibility is better.

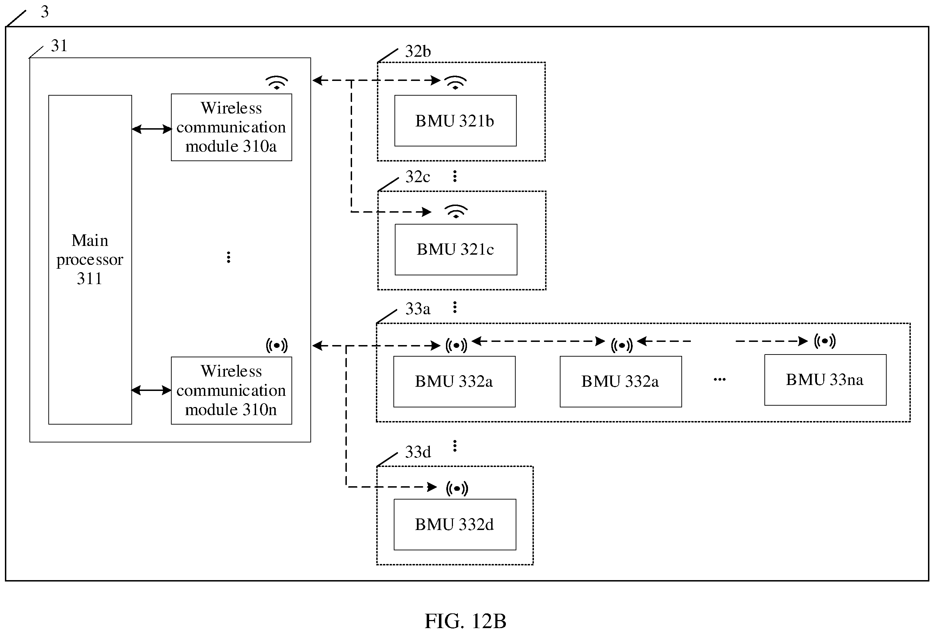

FIG. 12B is a diagram of another structure in which the battery management system uses the wireless BMIC according to an embodiment of this application. When there are the plurality of links of each wireless communication link in the BMS 3, as shown in FIG. 12B, the BMS 3 includes the main control unit 31, a wireless communication link 32b to a wireless communication link 32c, and a wireless communication link 33a to a wireless communication link 33d. The wireless communication link 32b to the wireless communication link 32c are one wireless communication link using a same communication protocol, ..., and the wireless communication link 33a to the wireless communication link 33d are another wireless communication link using a same communication protocol. The wireless communication link 32b includes a BMU 321b, ..., and the wireless communication link 32c includes a BMU 321c. Both the BMU 321b and the BMU 321c directly perform wireless communication with the wireless communication module 310a, to receive the instruction delivered by the main processor 311, or send, to the main processor 311, the battery parameter collected by the wireless BMIC inside the BMU 321b and the BMU 321c. The wireless communication link 33a includes the BMU 332a to the BMU 33na, ..., and the wireless communication link 33d includes a BMU 332d. Both the BMU 332a and the BMU 332d directly perform wireless communication with the wireless communication module 310n, to receive the instruction delivered by the main processor 311, or send, to the main processor 311, the battery parameter collected by the wireless BMIC inside the BMU 332a and the BMU 332d. Wireless communication is performed between the two adjacent BMUs in the BMU 332a to the BMU 33na, to transmit the battery parameter collected by the wireless BMIC or the instruction delivered by the main processor 311. This embodiment of this application is implemented, so that the BMUs of the different types of wireless BMICs can be used together in the same battery management system, and the system compatibility is better.

In some feasible implementations, the BMS 2 or the BMS 3 may be one of a battery management system in an electric vehicle battery system, a battery management system in a commercial and industrial energy storage system, and a battery management system in a power station container energy storage scenario. The foregoing is merely an example, and an actual application scenario of the BMS 2 or the BMS 3 is not limited in embodiments of this application.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A battery management system, BMS, wherein the BMS comprises a first battery monitoring unit, BMU and a second BMU, a communication protocol supported by a first battery management integrated circuit, BMIC comprised in the first BMU is different from a communication protocol supported by a second BMIC comprised in the second BMU, and each of the first BMU and the second BMU is configured to manage one or more cells in a battery pack;
each of the first BMU and the second BMU comprises a first-type input port, a first-type output port, a second-type input port, and a second-type output port;
the first BMIC is connected between the first-type input port of the first BMU and the first-type output port of the first BMU, and inside the first BMU, the second-type input port of the first BMU is connected to the second-type output port of the first BMU;
the second BMIC is connected between the second-type input port of the second BMU and the second-type output port of the second BMU, and inside the second BMU, the first-type input port of the second BMU is connected to the first-type output port of the second BMU; and
the first-type output port of the first BMU is connected to the first-type input port of the second BMU, and the second-type output port of the first BMU is connected to the second-type input port of the second BMU, so that the first BMU communicates with the second BMU.

2. The BMS according to claim 1, wherein the first-type input port comprises a first high-level input port and a first low-level input port, and the first-type output port comprises a first high-level output port and a first low-level output port; and the second-type input port comprises a second high-level input port and a second low-level input port, and the second-type output port comprises a second high-level output port and a second low-level output port;
inside the first BMU, the first high-level input port is connected to the first high-level output port via the first BMIC, the first low-level input port is connected to the first low-level output port via the first BMIC, the second high-level input port is connected to the second high-level output port, and the second low-level input port is connected to the second low-level output port; and
inside the second BMU, the first high-level input port is connected to the first high-level output port, the first low-level input port is connected to the first low-level output port, the second high-level input port is connected to the second high-level output port via the second BMIC, and the second low-level input port is connected to the second low-level output port via the second BMIC.

3. The BMS according to claim 2, wherein the first high-level output port of the first BMU is connected to the first high-level input port of the second BMU, and the first low-level output port of the first BMU is connected to the first low-level input port of the second BMU; and the second high-level output port of the first BMU is connected to the second high-level input port of the second BMU, and the second low-level output port of the first BMU is connected to the second low-level input port of the second BMU.

4. The BMS according to any one of claims 1 to 3, wherein the BMS further comprises a main control unit, the main control unit is configured to: manage a plurality of battery packs, and receive cell data reported by each BMU in the plurality of battery packs, the plurality of battery packs comprise battery packs in which the first BMU and the second BMU are located, and the main control unit comprises a first-type communication output port, a first-type communication input port, a second-type communication output port, and a second-type communication input port; and
the first-type communication output port is connected to the first-type input port of the first BMU, the first-type communication input port is connected to the first-type output port of the second BMU, the second-type communication output port is connected to the second-type input port of the first BMU, and the second-type communication input port is connected to the second-type output port of the second BMU.

5. The BMS according to any one of claims 1 to 3, wherein the first-type output port of the second BMU is configured to connect to a first-type input port of a third BMU, and the second-type output port of the second BMU is configured to connect to a second-type input port of the third BMU;
the first-type input port of the third BMU is configured to: inside the third BMU, connect to a first-type output port of the third BMU; and
the second-type input port of the third BMU is configured to connect to a third BMIC of the third BMU, wherein the third BMIC and the second BMIC support a same communication protocol.

6. A battery pack, wherein the battery pack comprises one or more first cells, one or more second cells, and the BMS according to any one of claims 1 to 3 or claim 5;
the first BMU is configured to collect cell data of the one or more first cells; and
the second BMU is configured to collect cell data of the one or more second cells.

7. An energy storage apparatus, wherein the energy storage apparatus comprises a first battery pack, a second battery pack, and the BMS according to any one of claims 1 to 3;
the first BMU is configured to collect cell data of a cell in the first battery pack; and
the second BMU is configured to collect cell data of a cell in the second battery pack.

8. The energy storage apparatus according to claim 7, wherein the energy storage apparatus further comprises a main control unit, the main control unit is configured to: manage the first battery pack and the second battery pack, and receive cell data reported by each BMU in the first battery pack and the second battery pack, and the main control unit comprises a first-type communication output port, a first-type communication input port, a second-type communication output port, and a second-type communication input port; and
the first-type communication output port is connected to a first-type input port of the first BMU, the first-type communication input port is connected to a first-type output port of the second BMU, the second-type communication output port is connected to a second-type input port of the first BMU, and the second-type communication input port is connected to a second-type output port of the second BMU.

9. The energy storage apparatus according to claim 7, wherein a first-type output port of the second BMU is configured to connect to a first-type input port of a third BMU, and a second-type output port of the second BMU is configured to connect to a second-type input port of the third BMU,
the first-type input port of the third BMU is configured to: inside the third BMU, connect to a first-type output port of the third BMU; and
the second-type input port of the third BMU is configured to connect to a third BMIC of the third BMU, wherein the third BMIC and the second BMIC support a same communication protocol.

10. An energy storage system, wherein the energy storage system comprises a power conversion system and the energy storage apparatus according to any one of claims 7 to 9, wherein
the power conversion system is configured to: convert a direct current output by the energy storage apparatus into an alternating current, or convert an alternating current into a direct current and input the direct current to the energy storage apparatus.
